# EUROPÄISCHE PATENTSCHRIFT

(11) **EP 0 902 729 B1**
(45) Veröffentlichungstag und Bekanntmachung des Hinweises auf die Patenterteilung: **03.05.2000**
(21) Anmeldenummer: 97915440.8
(22) Anmeldetag: 26.03.1997
(51) Int. Cl.: B05D 1/00, B05C 11/08, B05B 15/08, G03F 7/16

(54) **VERFAHREN UND VORRICHTUNG ZUM BESCHICHTEN VON SCHEIBENFÖRMIGEN INFORMATIONS-SPEICHERMEDIEN**
PROCESS AND DEVICE FOR COATING DISC-SHAPED DATA STORAGE MEDIA
PROCEDE ET DISPOSITIF POUR RECOUVRIR DES SUPPORTS DE DONNEES SOUS FORME DE DISQUES

(30) Priorität: 15.05.1996 DE 19619678
(43) Veröffentlichungstag der Anmeldung: 24.03.1999
(73) Patentinhaber: Steag HamaTech AG, 75447 Sternenfels (DE)
(72) Erfinder: WEBER, Klaus, D-75015 Bretten (DE); KALLIS, Martin, D-75417 Mühlacker (DE)
(86) Internationale Anmeldenummer: EP9701536
(87) Internationale Veröffentlichungsnummer: WO9743051

(56) Entgegenhaltungen:
- EP-A- 0 489 328
- EP-A- 0 618 504
- EP-A- 0 677 334
- US-A- 4 353 937
- US-A- 4 807 356

## Beschreibung

Die Erfindung betrifft ein Verfahren zum Beschichten von Informations-Speichermedien mit einem Beschichtungsmittel, das mittels wenigstens einer Beschichtungsdüse im Innenbereich des Speichermediums auf dieses aufgebracht und bei Drehen des Speichermediums durch die auftretende Zentrifugalkraft auf diesem verteilt wird. Die Erfindung betrifft weiterhin eine Vorrichtung zur Durchführung eines derartigen Verfahrens.

Scheibenförmige Informations-Speichermedien sind beispielsweise Kompakt-Scheiben (Compact Discs oder CD's), Mini-Scheiben (Mini Discs), magneto-optische Scheiben (Magneto-Optical Discs), CD-Rom's, CD-R's, Photo- und/oder Video-Scheiben (Photo-CD und/oder Video Discs). Im nachfolgenden werden diese Discs als scheibenförmige Informations-Speichermedien oder kurz als Speichermedien bezeichnet.

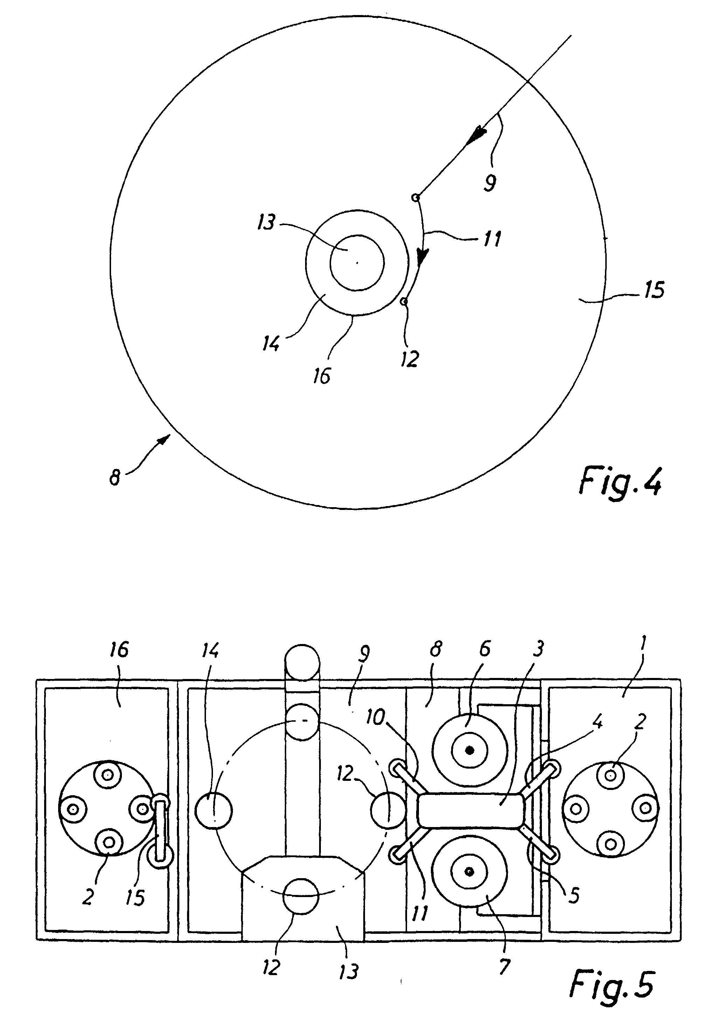

Vorrichtungen der eingangs genannten Art werden von der Anmelderin dieses Patents hergestellt und vertrieben. Fig. 5 zeigt eine schematische Darstellung der Vorrichtung bzw. des Ablaufs des Beschichtungs- und Trocknungsverfahrens in den jeweiligen Stationen dieser Vorrichtung.

In einer Geberstation 1 werden die scheibenförmigen Informations-Speichermedien 2 einer Handhabungseinrichtung 3 - im vorliegenden Fall einem sogenannten Prozess-Topf-Greifer - bereit gestellt, deren bzw. dessen der Geberstation 1 zugewandte Greiferarme 4,5 die von der Geberstation 1 bereitgestellten Speichermedien 2 ergreifen und zu den Beschichtungsstationen 6,7 einer Prozesseinheit 8 transportieren. Nach dem Beschichten der Speichermedien 2 mit einem Beschichtungsmittel, beispielsweise einem Beschichtungslack, werden die Speichermedien 2 mit den einer Trocknungsstation 9 zugewandten Greiferarmen 10,11 zu einer Empfangsposition 12 transportiert, von der sie in einer Trocknungskammer 13 gebracht werden. Nach dem Trockungsvorgang wird das Speichermedium 2 aus der Trockungskammer 13 in bzw. auf der Trocknungsstation in eine Lage 14 gebracht, in der es von einem weiteren Greifer 15 erfaßt und in bzw. auf die Nehmerstation 16 transportiert wird.

Die zuvor beschriebene Beschichtungsvorrichtungen für scheibenförmige Informations-Speichermedien wurden mit großem Erfolg bei der Herstellung derartiger Speichermedien eingesetzt.

Der Erfindung liegt die Aufgabe zugrunde, Beschichtungsverfahren und -vorrichtungen für scheibenförmige Informations-Speichermedien weiter zu verbessern und insbesondere Vorrichtungen zu schaffen, die pro Zeiteinheit noch mehr Beschichtungsabläufe ermöglichen, noch sicherer und mit weniger Standzeiten auskommen und einen geringeren Fertigungs- und Wartungsaufwand insbesondere für die Beschichtungsstationen ermöglichen.

Ausgehend von dem eingangs genannten Verfahren wird diese Aufgabe erfindungsgemäß dadurch gelöst, daß die wenigstens eine Beschichtungsdüse in einem ersten Bewegungsvorgang schnell in die Nähe des Beschichtungsmittel-Aufbringorts, und in einem zweiten Bewegungsvorgang langsam an den Aufbringort bewegt wird. Durch den ersten, schnellen Bewegungsvorgang wird die Beschichtungsdüse in kurzer Zeit in die Nähe des Beschichtungsmittel-Aufbringorts gebracht, um den Beschichtungsvorgang möglichst kurz zu halten und die Produktivität des Verfahrens zu erhöhen. Mit einem schnellen Bewegungsvorgang ist es jedoch zumindest in Zusammenhang mit hydraulischen Antriebseinrichtungen nicht oder nur mit hohem Apparateaufwand möglich, die Beschichtungsdüse genau an die Stelle zu bringen, an der das Beschichtungsmittel im Innenbereich des Speichermediums auf dieses aufgebracht werden muß. Wird nämlich die Beschichtungsdüse einerseits nicht weit genug nach innen an den vorgesehenen, optimalen Aufbringort bewegt, bleibt ein ungewollter Bereich des Speichermediums unbeschichtet. Fährt dagegen die Beschichtungsdüse über den optimalen Aufbringort nach innen weiter, erfolgt eine ungewollte Beschichtung des inneren Rands des im Innenbereich ausgeschnittenen Speichermediums oder eines inneren Ringbereichs des Speichermediums, der zur Handhabung des Speichermediums dient. Dies gilt insbesondere für die modernen, heutigen CDs die im Gegensatz zu den herkömmlichen CDs statt eines inneren Ausschnitts von 35 mm Durchmesser jetzt nur noch einen solchen von 15 mm Durchmesser aufweisen. Darüberhinaus weisen CDs im inneren Bereich auf der einen Seite eine kreisförmige Rille auf, die auf der anderen Seite des Speichermediums eine kreisförmige Erhebung bildet. Wird die Beschichtungdüse mit der ersten, schnellen Bewegung bis zu dieser kreisförmigen Rille oder bis zu dem kreisförmigen Vorsprung bewegt, wird die Rille oder der Vorsprung umgewollt mit Beschichtungsmittel versehen, das dann während des Schleudervorgangs ungleichmäßig auf die Fläche des Speichermediums verteilt wird und sich Streifen und ungleichmäßige Beschichtungsdicken über die Speichermedien-Fläche ausbilden. Diese Nachteile werden mit dem weiteren erfindungsgemäßen Merkmal der vorliegenden Erfindung sicher vermieden, indem ein zweiter Bewegungsvorgang vorgesehen ist, der die Beschichtungsdüse nach dem ersten, schnellen Bewegungsvorgang langsam an den Aufbringort bewegt.

Vorzugsweise ist die Geschwindigkeit, mit der die Beschichtungsdüse während des ersten und/oder zweiten Bewegungsvorgangs bewegt wird, je nach den Gegebenheiten ein- und nachstellbar. Dadurch können die Bewegungsgeschwindigkeiten während des ersten und/zweiten Bewegungsvorgangs individuell an die jeweiligen Abläufe, unterschiedlichen Speichermedien und/oder Beschichtungsmittel angepaßt werden.

Gemäß einer weiteren sehr vorteilhaften Ausführungsform erfolgt der erste, schnelle Bewegungsvorgang bei ruhendem Speichermedium, während beim zweiten, langsameren Bewegungsvorgangs das Speichermedium bereits in Bewegung versetzt wird, so daß dann, wenn die Beschichtungsdüse sich an dem vorgegebenen Aufbringort befindet, das Beschichtungsmittel sofort aufgebracht und über das Speichermedium geschleudert werden kann. Auf diese Weise ist es möglich, den Beschichtungsvorgang weiter zu verkürzen.

Ausgehend von einer Vorrichtung zum Beschichten von scheibenförmigen Informations-Speichermedien mit einem Beschichtungsmittel, mit einer drehbaren Auflage für das Speichermedium und wenigstens einer Beschichtungsdüse, die eine Antriebs-Einrichtung zur Bewegung der Beschichtungsdüse über dem Speichermedium an den Beschichtungsmittel-Aufbringort aufweist, wird die gestellte Aufgabe auch dadurch gelöst, daß die Antriebs-Einrichtung eine Hydraulikanordnung mit einem ersten Hydraulikzylinder für einen ersten, schnellen Bewegungsvorgang und einen zweiten Hydraulikzylinder für einen zweiten, langsamen Bewegungsvorgang der Beschichtungdüse aufweist. Die in Zusammenhang mit dem erfindungsgemäßen Verfahren genannten Vorteile gelten auch für die erfindungsgemäße Vorrichtung.

Grundsätzlich ist es möglich, als Antriebseinrichtung zur Bewegung der Beschichtungsdüse einen Schrittmotor zu verwenden, dessen Antriebsgeschwindigkeit steuerbar ist. Schrittmotoren für diesen Zweck sind jedoch wesentlich aufwendiger und teurer als Hydraulikanordnungen, so daß letztere auch in wirtschaftlicher Hinsicht einen wesentlichen Vorteil schaffen.

Gemäß einer vorteilhaften Ausgestaltung der Erfindung übernimmt der zweite Hydraulikzylinder den Antrieb der Beschichtungsdüse nach Beendigung des Antriebs durch den ersten Hydraulikzylinder. Besonders vorteilhaft ist jedoch eine Ausführungsform, gemäß deren der zweite Hydraulikzylinder während des zweiten, langsameren Bewegungsvorgang dem ersten Hydraulikzylinder entgegenwirkt. Der erste Hydraulikzylinder führt also bis zur Bewegung der Beschichtungsdüse an den Aufbringort oder kurz davor den Bewegungvorgang aus, die Bewegung wird lediglich durch den zweiten Hydraulikzylinder verlangsamt. Der zweite Hydraulikzylinder dient also in dieser Ausführungsform als Bremszylinder für den ersten Hydraulikzylinder.

Vorteilhaft ist es, wenn die Zylindergeschwindigkeit des ersten und/oder zweiten Hydraulikzylinders einstellbar, verstellbar, steuerbar und/oder regelbar ist. Der erste und/oder zweite Hydraulikzylinder weist daher Vorzugsweise eine entsprechend einstellbare Fluid-Drossel auf.

Die Erfindung wird nachfolgend anhand eines bevorzugten Ausführungsbeispiels unter Bezugnahme auf die Figuren erläutert. Es zeigen:
- Fig. 1: eine Darstellung einer erfindungsgemäßen Vorrichtung in einer ersten Blickrichtung;
- Fig. 2: die in Figur 1 dargestellte Vorrichtung in einer sich von der ersten Blickrichtung um 90 Grad unterscheidenden zweiten Blickrichtung;
- Fig. 3: die in den Figuren 1 und 2 dargestellte Vorrichtung in Aufsicht;
- Fig. 4: eine schematische Darstellung des zu beschichtenden Speichermediums in Aufsicht, zur Erläuterung des erfindungsgemäßen Bewegungsablaufs; und
- Fig. 5: eine schematische Darstellung einer gesamten Beschichtungsvorrichtung.

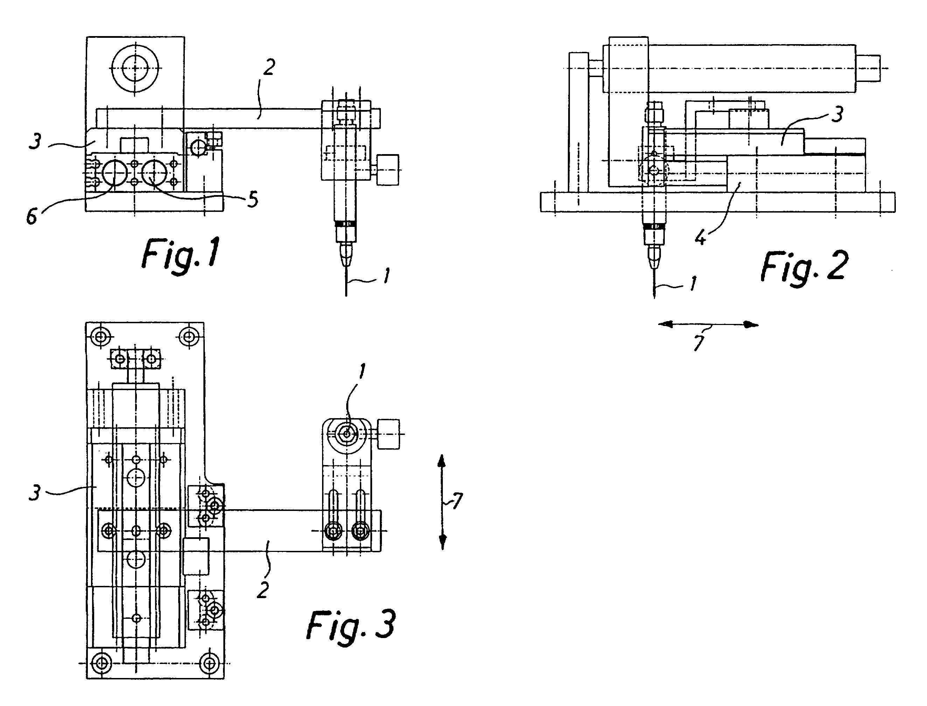

Wie in den Fig. 1 bis 3 dargestellt, ist eine Beschichtungsdüse 1 an einem Auslegerarm 2 befestigt, den ein Schlitten 3 trägt. Der Schlitten 3 ist auf einer Schlittenführung 4 gleitbar gelagert und wird bezüglich dieser Schlittenführung 4 mittels Hydraulikzylindern 5, 6 in der schematisch dargestellten Bewegungsrichtung 7 bewegt, so daß die Beschichtungsdüse 1 sich vom Rand eines zu beschichtenden Speichermediums 8 zu einem Aufbringungsort 12 (vgl. Fig. 4) bewegt, an dem die Beschichtungsdüse 1 in Funktion gesetzt und das Beschichtungsmittel auf das Speichermedium 8 gebracht wird.

Einer der Hydraulikzylinder 5, 6 dient als erster Hydraulikzylinder 5 bzw. 6 zum schnellen Verfahren der Beschichtungsdüse 1 über den größten Radialbereich des Speichermediums 8 hinweg bis zu einer Stelle 10, von der an die lineare Radialbewegung der Beschichtungsdüse 1 verlangsamt werden soll, bis sie an den vorgegebenen Aufbringungsort 12 oberhalb des Speichermediums 8 zum Stillstand kommt. Während dieses letzten Bewegungsabschnitts wirkt der zweite Hydraulikzylinder 6 bzw. 5 dem ersten Hydraulikzylinder 5 bzw. 6 entgegen und wirkt dadurch als Bremszylinder.

Fig. 4 zeigt eine schematische Darstellung des Bewegungsablaufs der Beschichtungsdüse 1 bezüglich des Speichermediums 8. Zu diesem Zwecke ist ein zu beschichtendes Speichermedium 8, beispielsweise eine CD, in Aufsicht dargestellt, wie es auf einer nicht wiedergegebenen Drehscheibe während des Beschichtungsvorgangs liegt. Das Speichermedium 8 wird zunächst noch nicht gedreht und die Beschichtungsdüse 1 wird in einem linearen Bewegungsvorgang 9 radial zum Mittelpunkt des Speichermediums 8 hindurch Antrieb mit dem ersten Hydraulikzylinder 5 bzw. 6 zu einer Stelle 10 bewegt, von der an der Bremszylinder 6 bzw. 5 in Funktion gesetzt, und die Geschwindigkeit des ersten Hydraulikzylinders 5 bzw.6 und damit der Beschichtungsdüse 1 verringert werden. Bei dem dargestellten Ausführungsbeispiel wird von dem Zeitpunkt an von dem sich die Beschichtungsdüse 1 an der Stelle 10 befindet, also vom Zeitpunkt des In-Funktion-Setzens des zweiten Hydraulikzylinders 6 bzw. 5 an, in Drehung versetzt, so daß bei linearer Bewegung der Beschichtungsdüse 1 diese sich während eines Bewegungsvorgangs 11 relativ zur Oberfläche des Speichermediums 8 zum Beschichtungsmittel-Aufbringort 12 bewegt, der sehr genau definiert angefahren werden kann, weil die Bewegung zwischen der Stelle 10 und dem Aufbringort 12 langsam verläuft. Sobald die Beschichtungsdüse 1 den Aufbringort 12 erreicht hat, kann sofort mit dem Aufbringen des Beschichtungsmittels auf das Speichermedium 8 begonnen werden, da dieses sich bereits in Rotation befindet, und das Beschichtungsmittel über die Speichermedium-Fläche gleichmäßig nach außen geschleudert wird.

Wie in Fig. 4 schematisch dargestellt ist, weist die in diesem Ausführungsbeispiel als Speichermedium 8 vorgesehene CD einen ausgeschnittenen Freiraum 13 und einen inneren Ringbereich 14 auf zur Handhabung der CD, der gegenüber dem zu beschichtenden Außenbereich 15 der CD 8 mittels einer kreisförmigen Rille 16 bzw. einer kreisförmigen, komplementären Erhebung auf der anderen Seite der CD 8 abgegrenzt ist.

Das erfindungsgemäße Verfahren und/oder die erfindungsgemäße Vorrichtung ermöglichen eine einfache, präzise Beschichtung von Speichermitteln 8 mit geringem apparatemäßigen und Wartungs-Aufwand und einer hohen Produktivitätsrate durch ein zunächst schnelles und danach in der Nähe des Aufbringorts 12 langsames Verfahren der Beschichtungsdüse 1 bis zum Aufbringort 12 in sehr präziser Weise, wobei einerseits der gesamte Bereich außerhalb der kreisförmigen Rille 16 zuverlässig beschichtet wird, andererseits aber sicher verhindert wird, daß das Beschichtungsmedium in diese Rille 16 bzw. auf die komplementäre Erhebung gelangt, was zur Streifenbildung auf der CD führen würde. Auch ist zuverlässig sichergestellt, daß kein Beschichtungsmittel auf dem inneren Ringbereich 14 aufgebracht wird, so daß Handhabungseinrichtungen nicht mit dem Beschichtungsmittel in Berührung kommen und verschmutzt werden können.

Die Erfindung wurde zuvor anhand eines bevorzugten Ausfühungsbeispiels beschrieben. Dem Fachmann sind jedoch zahlreiche Abwandlungen und Ausgestaltungen möglich, im Rahmen des Wortlauts der Ansprüche 1 und 4.

## Patentansprüche

1. Verfahren zum Beschichten von scheibenförmigen Informations-Speichermedien (8) mit einem Beschichtungsmittel, das mittels wenigstens einer Beschichtungsdüse (1) im Innenbereich des Speichermediums (8) auf diesem aufgebracht und bei Drehen des Speichermediums (8) durch die dabei auftretende Zentrifugalkraft auf diesem verteilt wird, dadurch gekennzeichnet, daß die Beschichtungsdüse (1) in einem ersten Bewegungsvorgang (9) schnell in die Nähe (10) des Beschichtungsmittel-Aufbringorts (12) und in einem zweiten Bewegungsvorgang (11) langsam an den Aufbringungsort (12) bewegt wird.

2. Verfahren nach Anspruch 1, dadurch gekennzeichnet, daß die Geschwindigkeit, mit der die Beschichtungsdüse (1) während des ersten und/oder zweiten Bewegungsvorgangs (9 bzw. 11) bewegt wirde, einstellbar ist.

3. Verfahren nach Anspruch 1 oder 2, dadurch gekennzeichnet, daß das Speichermedium (8) während des zweiten Bewegungsvorgangs (11) in Drehbewegung versetzt wird.

4. Vorrichtung zum Beschichten von scheibenförmigen Informations-Speichermedien (8) mit einem Beschichtungsmittel, mit einer drehbaren Auflage für das Speichermedium (8) und wenigstens einer Beschichtungsdüse (1), die eine Antriebseinrichtung (5, 6) zu ihrer Bewegung über dem Speichermedium (8) an den Beschichtungsmittel-Aufbringort (12) aufweist, dadurch gekennzeichnet, daß die Antriebseinrichtung (5, 6) einer Hydraulikanordnung mit einem ersten Hydraulikzylinder (5 bzw. 6) für eine erste, schnelle Bewegung und einem zweiten Hydraulikzylinder (6 bzw. 5) für eine zweite, langsame Bewegung der Beschichtungsdüse (1) umfaßt.

5. Vorrichtung nach Anspruch 4, dadurch gekennzeichnet, daß der zweite Hydraulikzylinder (6 bzw. 5) den Antrieb der Beschichtungsdüse (1) nach Beendigung des Antriebs durch den ersten Hydraulikzylinder (5 bzw. 6) übernimmt.

6. Vorrichtung nach Anspruch 4, dadurch gekennzeichnet, daß der zweite Hydraulikzylinder (6 bzw. 5) während des zweiten, langsameren Bewegungsvorgangs (12) dem ersten Hydraulikzylinder (5 bzw. 6) entgegenwirkt.

7. Vorrichtung nach Anspruch 6, dadurch gekennzeichnet, daß der zweite Hydraulikzylinder (6 bzw. 5) als Bremszylinder für den ersten Hydraulikzylinder (5 bzw. 6) dient.

8. Vorrichtung nach einem der Ansprüche 4 bis 7, dadurch gekennzeichnet, daß der erste und/oder zweite Hydraulikzylinder (5 bzw. 6; 6 bzw. 5) eine einstellbare Fluid-Drossel aufweist.

## Claims

1. Method of coating disc-shaped data storage media (8) with a coating means which by means of at least one coating nozzle (1) is applied thereto in the inner region of the storage medium (8) and is distributed thereon on rotation of the storage medium (8) by the centrifugal force arising in that case, characterised in that the coating nozzle (1) is moved quickly into the vicinity (10) of the coating means application location (12) in a first movement process (9) and slowly to the application location (12) in a second movement process (11).

2. Method according to claim 1, characterised in that the speed at which the coating nozzle (1) is moved during the first and/or second movement process (9 or 11) is adjustable.

3. Method according to claim 1 or 2, characterised in that the storage medium (8) is set into rotational movement during the second movement process (11).

4. Device for coating disc-shaped data storage media (8) with a coating means, with a rotatable support for the storage medium (8) and at least one coating nozzle (1), which comprises a drive device (5, 6) for movement thereof over the storage medium (8) to the coating means application location (12), characterised in that the drive device (5, 6) comprises a hydraulic arrangement with a first hydraulic cylinder (5 or 6) for a first, quick movement and a second hydraulic cylinder (6 or 5) for a second, slow movement of the coating nozzle (1).

5. Device according to claim 4, characterised in that the second hydraulic cylinder (6 or 5) takes over the drive of the coating nozzle (1) after conclusion of the drive by the first hydraulic cylinder (5 or 6).

6. Device according to claim 4, characterised in that the second hydraulic cylinder (6 or 5) counteracts the first hydraulic cylinder (5 or 6) during the second, slower movement process (12).

7. Device according to claim 6, characterised in that the second hydraulic cylinder (6 or 5) serves as a braking cylinder for the first hydraulic cylinder (5 or 6).

8. Device according to one of claims 4 to 7, characterised in that the first and/or. second hydraulic cylinder (5 or 6; 6 or 5) has a settable fluid throttle.

## Revendications

1. Procédé pour recouvrir des supports de stockage d'informations en forme de disque (8) d'un moyen de recouvrement qui est appliqué au moyen d'au moins une buse de recouvrement (1) dans la zone intérieure du support de stockage (8) sur celui-ci et qui, lors de la rotation du support de stockage (8), est réparti par la force centrifuge ainsi produite sur celui-ci, caractérisé en ce que la buse de recouvrement (1) est déplacée lors d'une première étape de mouvement (9) rapidement au voisinage (10) de l'emplacement d'application (12) du moyen de recouvrement et lors d'une deuxième étape de mouvement (11) lentement à l'emplacement d'application (12).

2. Procédé selon la revendication 1, caractérisé en ce que la vitesse avec laquelle la buse de recouvrement (1) est déplacée pendant la première et/ou deuxième étape de mouvement (9 respectivement 11) est réglable.

3. Procédé selon la revendication 1 ou 2, caractérisé en ce que le support de stockage (8), pendant la deuxième étape de mouvement (11), est entraîné en rotation.

4. Dispositif pour recouvrir des supports de stockage d'informations (8) en forme de disque avec un moyen de recouvrement, avec un support tournant pour le support de stockage (8) et avec au moins une buse de recouvrement (1) qui présente une installation d'entraînement (5, 6) pour son déplacement sur le support de stockage (8) au lieu d'application (12) du moyen de recouvrement, caractérisé en ce que l'installation d'entraînement (5, 6) comprend un agencement hydraulique avec un premier vérin hydraulique (5 respectivement 6) pour un premier mouvement rapide et un deuxième vérin hydraulique (6 respectivement 5) pour un deuxième mouvement lent de la buse de recouvrement (1).

5. Dispositif selon la revendication 4, caractérisé en ce que le deuxième vérin hydraulique (6 respectivement 5) reprend l'entraînement de la buse de recouvrement (1) après la fin de l'entraînement par le premier vérin hydraulique (5 respectivement 6).

6. Dispositif selon la revendication 4, caractérisé en ce que le deuxième vérin hydraulique (6 respectivement 5), pendant la deuxième étape de mouvement plus lente (12), agit contre le premier vérin hydraulique (5 respectivement 6).

7. Dispositif selon la revendication 6, caractérisé en ce que le deuxième vérin hydraulique (6 respectivement 5) sert de cylindre de freinage au premier vérin hydraulique (5 respectivement 6).

8. Dispositif selon l'une des revendications 4 à 7, caractérisé en ce que le premier et/ou deuxième vérin hydraulique (5 respectivement 6 ; 6 respectivement 5) présente un papillon de fluide réglable.
